Europäisches Patentamt

European Patent Office

Office européen des brevets

(19)

(11) Veröffentlichungsnummer: **0 016 854**
A1

# (12) EUROPÄISCHE PATENTANMELDUNG

(21) Anmeldenummer: 79102034.0

(22) Anmeldetag: 20.06.79

(51) Int. Cl.³: **H 01 H 47/18**, H 03 K 17/28, B 60 Q 3/02

(30) Priorität: 20.03.79 DE 2910872

(43) Veröffentlichungstag der Anmeldung: 15.10.80
Patentblatt 80/21

(84) Benannte Vertragsstaaten: **FR GB SE**

(71) Anmelder: **Firma Leopold Kostal, Wiesenstrasse 47, D-5880 Lüdenscheid (DE)**

(72) Erfinder: **Bergmann, Eduard, Altenaer Strasse 1, D-5880 Lüdenscheid (DE)**
Erfinder: **Hülsmann, Ulrich, Volmestrasse 56, D-5800 Hagen (DE)**

(74) Vertreter: **Hassler, Werner, Dr. et al, Patentanwälte Dr. W. Hassler, Dipl.-Chem. F. Schrumpf Postfach 1704, D-5880 Lüdenscheid (DE)**

(54) **Zeitgeberschaltung.**

(57) In einer Zeitgeberschaltung mit einstellbaren, in einem Zeitbereich von Sekunden bis Minuten liegenden Zeitdauer für die Erregung eines Schaltkreises fließt der Entladestrom über die Emitter-Kollektorstrecke eines Transistors ($T_3$), dessen Basis an den Teilpunkt ($T_p$) einer Spannungsteilerschaltung ($R_1$, $R_2$) angeschlossen ist. Anwendungsgebiet der Zeitgeberschaltung ist die Kraftfahrzeugelektronik, wo die Schaltung zum automatischen Abschalten einer Heckscheibenheizung oder auch zum verzögerten Abschalten der Innenraumbeleuchtung eingesetzt werden kann.

Patentanwalt
Dr. W. Häußler
Dipl.-Chem. F. Schrumpf
Postfach 17 04

5880 Lüdenscheid

– 1 –

Lüdenscheid, den 5. März 1979

A 7951

Anmelderin: Firma Leopold Kostal

Wiesenstr. 47

5880 Lüdenscheid


Zeitgeberschaltung


Beschreibung


Die Erfindung betrifft eine Zeitgeberschaltung mit einem über einen Tastschalter an eine Spannungsquelle angeschlossenen Kondensator und einem parallel zum Kondensator an die Spannungsquelle angeschlossenen Entladewiderstand.

Anwendungsgebiet der Zeitgeberschaltung nach der Erfindung ist die Kraftfahrzeugelektronik. Die Zeitgeberschaltung kann zum automatischen Abschalten einer Heckscheibenheizung oder auch für die verzögerte Abschaltung der Innenraumbeleuchtung eingesetzt werden.

Aufgabe der Erfindung ist die Einsatzmöglichkeit der Schaltung innerhalb eines sehr großen Bereichs für Abschaltzeiten zwischen einigen Sekunden und einer Vielzahl von Minuten.

Diese Aufgabe wird nach der Erfindung dadurch gelöst, daß der Entladewiderstand über die Emitter-Kollektorstrecke eines Transistors an den Kondensator angeschlossen ist und daß die Basis des Entladetransistors an den Teilpunkt einer Spannungsteilerschaltung angeschlossen ist.

Durch diese Schaltung erreicht man, daß mit Hilfe der Widerstände der Spannungsteilerschaltung sowie des Entladewiderstandes und des Kondensators ein sehr großer Zeitbereich beherrscht werden kann, der von einigen wenigen Sekunden bis zu einer Vielzahl von Minuten reicht. Außerdem kann durch geeignete Wahl der genannten Widerstände eine weitgehende Spannungs- und Temperaturunabhängigkeit der Schaltung erreicht werden. Die Schaltung ist über den Tastschalter jederzeit einschaltbar und auslösbar.

0016854

Bei jeweils erneuter Betätigung des Tastschalters läuft immer die gesamte Zeitdauer der Zeitgeberschaltung von neuem ab. Die Zeitgeberschaltung eignet sich im Minutenbereich zum automatischen Abschalten einer Heckscheibenheizung oder im Sekundenbereich zum Abschalten der Innenraumbeleuchtung nach Zuschlagen der Fahrzeugtür.

Damit ein Relais sicher angesteuert werden kann, schlägt die Erfindung vor, daß an die Kollektorleitung des Entladetransistors die Eingangsleitung einer elektronischen Schaltstufe für ein Relais angeschlossen ist. Im einzelnen ist die Eingangsleitung die Basisleitung eines Transistors, dessen Emitterleitung mit der Basis eines Schalttransistors verbunden ist, in dessen Kollektorkreis ein Relais liegt.

Damit die Zeitgeberschaltung nach der Erfindung verpolsicher ausgebildet ist, sieht die Erfindung in der Kollektorleitung eines Transistors der elektronischen Schaltstufe eine Diode vor, die nur in einer Stromrichtung den Strom durchläßt.

Eine Ausführungsform der Erfindung wird im folgenden unter Bezugnahme auf die anliegende Zeichnung erläutert, die ein Beispiel der Zeitgeberschaltung nach der Erfindung zeigt.

Die Schaltung nach der Erfindung ist zwischen einer Bezugsspannungsleitung O und einer Versorgungsspannungsleitung $+U_B$ der Bordspannungsquelle aufgebaut. Zwischen der Versorgungsspannungsleitung $+U_B$ und der Bezugsspannungsleitung O ist zunächst ein Spannungsteiler aus den Widerständen $R_1$ und $R_2$ mit einem Teilpunkt Tp vorgesehen. Der Teilpunkt Tp ist an die Basis eines Transistors $T_3$ angeschlossen, dessen Emitterleitung über einen Entladewiderstand $R_3$ mit der Versorgungsspannungsleitung $+U_B$ und dessen Kollektor über einen nichtrastenden Tastschalter Ta mit der Bezugsspannungsleitung O verbunden ist. Die Kollektorleitung ist außerdem über einen Elektrolytkondensator $C_1$ mit der Versorgungsspannungsleitung $+U_B$ verbunden. An die Kollektorleitung ist außerdem die Basisleitung

eines Transistors $T_2$ angekoppelt, dessen Kollektor mit der Bezugsspannungsleitung O verbunden ist und dessen Emitter über einen Widerstand $R_4$ mit der Basis eines Schalttransistors $T_1$ verbunden ist. Der Emitter des Schalttransistors $T_1$ ist mit der Versorgungsspannungsleitung $+U_B$ und der Kollektor der Schalttransistors $T_1$ über ein Relais Rl mit der Bezugsspannungsleitung O verbunden. Der Relaiskontakt rl des Relais Rl liegt in einem Verbraucherstromkreis, der von der Versorgungsspannungsleitung $+U_B$ über einen Verbraucher V zur Bezugsspannungsleitung O führt.

In die Kollektorleitung des Transistors $T_2$ kann wahlweise eine Diode $D_1$ eingefügt sein, die bei richtiger Polung der Zeitgeberschaltung in Durchlaßrichtung angeschlossen ist. Diese Diode $D_1$ bietet eine Verpolsicherheit der Schaltung.

Durch Betätigung des Tasters Ta wird der Kondensator $C_1$ auf die Versorgungsspannung der Bordspannungsquelle aufgeladen. Die Transistoren $T_1$ und $T_2$ werden in ihren Leitungszustand durchgeschaltet, so daß das Relais Rl den Verbraucher V einschaltet. Beim Loslassen des Tasters Ta wird die Verbindung mit der Bezugsspannungsleitung O aufgetrennt, so daß sich der Kondensator $C_1$ über die Emitter-Kollektor-Strecke des Transistors $T_3$ und den Widerstand $R_3$ entlädt. Dieser Entladevorgang wird durch den Basisstrom des Transistors $T_2$ im wesentlichen nicht beeinflußt. Der Entladestrom $I_E$ berechnet sich wie folgt:

$$I_E = \frac{U_B \dfrac{R_1}{R_1 + R_2} - U_{BE}}{R_3}$$

wobei $U_{BE}$ die Basis-Emitter-Spannung des Transistors $T_3$ ist. Die zeitbestimmende Gleichung für den Entladevorgang lautet:

$$t = \frac{C \cdot U_B \cdot R_3}{U_B \dfrac{R_1}{R_1 + R_2} - U_{BE}}$$

Während der Entladung bleibt zu Beginn das Basispotential

des Transistors $T_2$ klein, so daß dieser Transistor $T_2$ durchgeschaltet bleibt und damit das Relais R1 in seinem angezogenen Zustand gehalten wird. Mit weiterem Fortschreiten des Entladevorgangs steigt das Basispotential des Transistors $T_2$ an. Die Schaltzeit oder Haltezeit der Zeitgeberschaltung wird durch dieses Basispotential bestimmt.

Man erkennt aus der obigen Gleichung für die Schaltzeit, daß dieselbe durch geeignete Wahl der Schaltungsparameter im wesentlichen temperaturunabhängig und spannungsunabhängig gemacht werden kann.

Der Basisstrom des Transistors $T_2$ liegt im $\mu$A-Bereich, so daß der Entladestrom praktisch nicht beeinflußt wird.

0016854

...ßler
...J. Schrumpf
... 17 04

5880 Lüdenscheid
Anmelderin: Firma

Leopold Kostal
Wiesenstr. 47
5880 Lüdenscheid

Lüdenscheid, 5. März 1979
A 79 51

## Zeitgeberschaltung

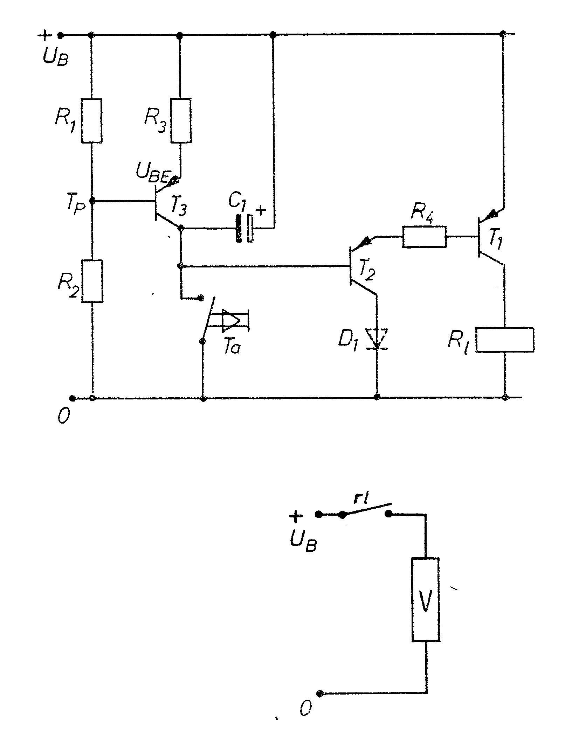

## Patentansprüche

1. Zeitgeberschaltung mit einem über einen Tastschalter an eine Spannungsquelle angeschlossenen Kondensator und einem parallel zum Kondensator an die Spannungsquelle angeschlossenen Entladewiderstand, dadurch gekennzeichnet, daß der Entladewiderstand $(R_3)$ über die Emitter-Kollektor-Strecke eines Transistors $(T_3)$ an den Kondensator $(C_1)$ angeschlossen ist und daß die Basis des Entladetransistors $(T_3)$ an den Teilpunkt (Tp) einer Spannungsteilerschaltung angeschlossen ist.

2. Zeitgeberschaltung nach Anspruch 1, dadurch gekennzeichnet, daß an die Kollekorleitung des Entladetransistors $(T_3)$ die Eingangsleitung einer elektronischen Schaltstufe für ein Relais (Rl) angeschlossen ist.

3. Zeitgeberschaltung nach Anspruch 2, dadurch gekennzeichnet, daß die Eingangsleitung der elektronischen Schaltstufe die Basisleitung eines Transistors $(T_2)$ ist, dessen Emitter-Leitung mit der Basis eines Schalttransistors $(T_1)$ verbunden ist, in dessen Kollektorkreis das Relais (Rl) liegt.

4. Zeitgeberschaltung nach einem der Ansprüche 1 bis 3, dadurch gekennzeichnet, daß zur Erzielung einer Verpolsicherheit in die Kollektorleitung des Transistors $(T_2)$ eine Diode $(D_1)$ eingeschaltet ist.

### EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE – C – 1 152 145 (VEB ELEKTRO-APPA-RATEWERKE BERLIN-TREPTOW) <br> * Ansprüche 1 und 2; Fig. 2 * <br> -- | 1 |
| | DE – C – 1 240 567 (MAX GRUNDIG) <br> * Anspruch 1; Fig. * <br> -- | 1 |
| A | DE – B2 – 2 428 083 (SWF-SPEZIALFABRIK FÜR AUTOZUBEHÖR GUSTAV RAU GMBH) <br> * gesamtes Dokument * <br> -- | 1 |
| A | DE – B2 – 2 141 935 (MITSUBISHI DENKI K.K.) <br> * Fig. 2 * <br> -- | 1 |
| A | DE – B – 1 284 991 (METRAWATT AG) <br> * Anspruch 1; Fig. 1 * <br> -- | 1 |
| P | DE – A1 – 2 754 690 (KRONE GMBH) <br> * Seite 7, Zeile 3 bis Seite 8, Zeile 16; Fig. 1 * <br> -- | 1 |
| A | DE – A – 2 208 637 (FABBRICA ITALIANA MAGNETI MARELLI S.P.A.) <br> * Seite 5, Zeile 1 bis Seite 7, Zeile 4; Fig. 1 * <br> ---- | 1 |

**KLASSIFIKATION DER ANMELDUNG (Int.Cl.)**

H 01 H 47/18
H 03 K 17/28
B 60 Q 3/02

**RECHERCHIERTE SACHGEBIETE (Int. Cl.)**

B 60 Q 3/02
B 60 L 1/02
H 01 H 47/18
H 03 K 17/28

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Berlin | 19-06-1980 | ARENDT |

EPA form 1503.1 08.78